# DEMANDE DE BREVET EUROPEEN

(11) **EP 1 528 688 A2**
(43) Date de publication de la demande: **04.05.2005**
(21) Numéro de dépôt: 04292102.3
(22) Date de dépôt: 27.08.2004
(51) Int. Cl.: H03M 13/29, H03M 13/37, H04L 1/00

(54) **Architecture pour un decodeur iteratif**

(30) Priorité: 28.08.2003 FR 0310261
(71) Demandeur: AGENCE SPATIALE EUROPEENNE, F-75738 Paris Cedex 15 (FR)
(72) Inventeur: Martinez, Alfonso, 1017 WC Amsterdam (NL); Rovini, Massimo, 56014 Putignano PISA (IT)
(74) Mandataire: Jacquard, Philippe Jean-Luc

(57) **Abrégé**

Décodeur itératif (20) comportant une pluralité de serveurs (22) qui effectuent le décodage itératif d'un bloc de données chacun, une mémoire tampon d'entrée (23) et une unité de contrôle (21) qui effectue un multiplexage statistique des données en entrée, qui sont d'abord stockées dans la mémoire tampon d'entrée (23) et successivement traitées par l'un des serveurs (22). La mémoire tampon d'entrée (23) comporte N+L emplacements de mémoire, où N et le nombre de serveurs (22) et L est le nombre d'emplacements dits supplémentaires. Chaque bloc à décoder qui est reçu pendant que tous les serveurs (22) sont occupés est stocké dans l'un des L emplacements supplémentaires éventuellement disponibles, ou il est perdu si la mémoire tampon d'entrée (23) est entièrement remplie. Le nombre L d'emplacements supplémentaires et le nombre N de serveurs sont calculés sur la base d'un modèle de file d'attente du type D/G/N/N+L de telle sorte que la probabilité P_{B} qu'un bloc soit perdu vérifie la condition P_{B}≤α·FER*, où FER* est le taux d'erreur sur les blocs admis et α<1 ; typiquement α est de l'ordre de 0,01. Procédé de fabrication d'un tel décodeur itératif comportant une étape de conception et une étape de réalisation matérielle.

## Description

L'invention porte sur un décodeur itératif, et plus particulièrement sur un décodeur itératif destiné à être réalisé sous forme d'un circuit intégré, ou une pluralité de circuits intégrés, en technologie d'intégration à très grande échelle (VLSI). Ce décodeur présente une nouvelle architecture permettant de réduire considérablement la complexité (aire de silicium occupée) et/ou la consommation de puissance par rapport aux décodeurs connus de l'art antérieur et/ou d'augmenter le débit de données pour une complexité et une consommation de puissance données ; pour cette raison elle convient particulièrement aux applications spatiales et à la téléphonie mobile.

La transmission d'un signal numérique sur un canal bruité comporte généralement l'utilisation d'un code de correction des erreurs afin d'obtenir un taux d'erreur sur les bits (Bit Error Rate, BER) ou sur les blocs (Frame Error Rate, FER) acceptable même avec un faible écart signal et bruit. En règle générale, l'opération de décodage est plus complexe que celle de codage aussi bien en terme de mémoire, et donc d'aire de silicium occupée, que de temps de calcul.

Parmi les différents algorithmes de codages et décodage qui ont été développés, les codes itératifs, tels que les « codes turbo », ont acquis une grande importance ces dernières années. Ces codes sont décrits, par exemple, dans les articles suivants :
« Near Shannon limit error-correcting coding and decoding: Turbo codes », P. Thitimajshima, C. Berrou, A Glavieux, IEEE ICC 93, pages 1064-1070, 1993 Genève; et
« Near-optimum decoding of product codes: Block turbo codes », R.M. Pyndiah, IEEE Transactions on Communications, 46(8): 1003-1010, 1998;
ainsi que dans le Brevet Européen EP 0 753 696 et dans la Demande Internationale WO 01/06661.

Les codes « turbo » sont obtenus par une concaténation en parallèle de codes convolutionnels ; les codes obtenus par concaténation en série de codes convolutionnels, qui ont des propriétés similaires et constituent également un domaine d'application de la présente invention sont connus comme codes « turbo-like ».

Ces codes se caractérisent par le fait que le décodage est une procédure itérative et à chaque itération le BER et le FER diminuent. Souvent le nombre Nᵢₜ d'itérations est fixe et il est déterminé en considérant le cas des blocs les plus corrompus par le bruit. Il est évident que cela comporte un gaspillage de ressources, car la plupart des blocs subissent plus d'itérations que nécessaire. Pour cette raison des règles d'arrêt ont été envisagées ; voir à ce propos :
« Stopping rules for turbo decoders » F. Pollara, A. Matache, S. Dolinar, Technical Report 42-142, TMO Progress Report, Août 2000; et
« A simple stopping criterion for turbo decoding » W.J. Ebel, Y. Wu, B.D. Woermer, IEEE Communications Letters, 4(8): 258-260 (2000).

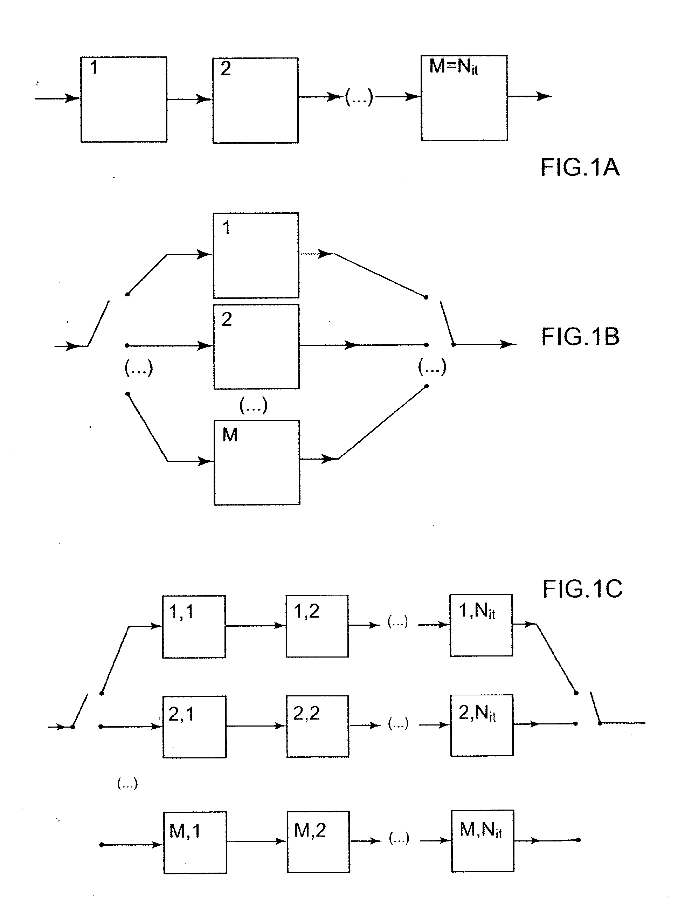

Pour augmenter le débit de données, on utilise typiquement des décodeurs constitués par plusieurs répliques du même module de décodage, chaque module prenant en charge le traitement d'un bloc de bits. En faisant abstraction des problèmes liés au multiplexage à l'entrée et au démultiplexage à la sortie, le débit est proportionnel au nombre M de modules utilisés. Il existe essentiellement trois architectures basées sur ce principe : l'architecture pipe-line, l'architecture parallèle et l'architecture matricielle, qui sont illustrées par les figures 1 A, 1 B et 1 C respectivement.

Dans l'architecture pipe-line, M=Nᵢₜ modules sont connectés en série comme dans une chaîne d'assemblage. Un bloc de bits introduit à l'entrée de la chaîne en sort après avoir été traité une fois par chaque module, donc après avoir subi Nᵢₜ itérations.

Dans l'architecture parallèle, M modules effectuent chacun le décodage complet (Nᵢₜ itérations) d'un bloc de bits. Il est facile de se rendre compte que si M=Nᵢₜ les performances d'un décodeur parallèle sont les mêmes que celles d'un décodeur pipe-line, aussi bien en terme de complexité que de débit. Si M>Nᵢₜ, le débit est plus élevé, mais la complexité aussi, alors que l'effet inverse est obtenu pour M<Nᵢₜ. Ici et dans la suite de ce document, on entend par « complexité » une grandeur proportionnelle à l'aire occupée sur une puce électronique par un circuit qui réalise le décodeur. La complexité dépend aussi bien de l'architecture du décodeur que de la technologie microélectronique choisie ; pour une technologie donnée, la complexité permet de comparer différentes architectures.

L'architecture matricielle n'est qu'une généralisation des deux précédentes : un décodeur matriciel se compose de M décodeurs pipe-fine en parallèle.

Ces architectures sont essentiellement équivalentes et le choix d'en utiliser une plutôt qu'une autre dépend de considérations spécifiques à l'application considérée. Un décodeur basé sur l'une quelconque d'entre elles ne peut fonctionner que pour un nombre fixé d'itérations, ce qui comporte un gaspillage de ressources matérielles et une consommation d'énergie plus élevée que nécessaire.

Plus récemment, des architectures de décodeurs modulaires permettant l'application de règles d'arrêt ont été développées.

Le document DE 102 14 393, qui représente l'état de la technique le plus proche, divulgue un décodeur itératif comprenant une pluralité de serveurs, chacun effectuant le décodage itératif d'un bloc de données, une mémoire tampon d'entrée comprenant un nombre d'emplacement de mémoire supérieur au nombre des serveurs et une unité de contrôle pour attribuer des blocs de données stockés dans la mémoire tampon d'entrée aux différents serveurs.

Le document WO 02/067435 A1 décrit un décodeur comportant une pluralité de modules de décodage en parallèle et un dispositif d'allocation dynamique des paquets de données entrants. Bien que le dispositif d'allocation soit équipé d'une mémoire temporaire, le décodeur est conçu de telle sorte que la probabilité qu'un paquet de données entrant ne trouve aucun module de décodage libre soit faible. Pour que cette condition soit vérifiée, il faut utiliser un grand nombre de modules, dont au moins un sera inoccupé presque à chaque instant : il en résulte donc un gaspillage de ressources matérielles. De plus, ce document ne fournit aucune information permettant de déterminer le nombre des modules de décodage et des éléments de la mémoire temporaire en fonction des performances requises et des conditions de fonctionnement du décodeur.

Le document EP 0 973 292 A2 décrit l'utilisation d'une mémoire tampon (buffer) pour chaque module de décodage (appelé aussi « serveur »), de façon à réaliser autant de files d'attente que de modules, plus éventuellement une mémoire tampon globale au niveau du dispositif d'allocation. Dans ce document l'utilisation d'un critère d'arrêt n'est pas décrite : au contraire, le nombre d'itérations est déterminé a priori sur la base du rapport entre la puissance de la porteuse et celle du bruit. Tant que ce rapport reste constant, la durée du décodage est la même pour tous les paquets : il y a donc le même problème de surdimensionnement rencontré dans les architectures à nombre fixé d'itérations décrites ci-dessus.

Un objet de la présente invention est un décodeur itératif présentant une nouvelle architecture qui permet une meilleure utilisation des ressources matérielles par rapport à l'art antérieur. Une telle architecture est dénommée « matrice de serveurs opérant simultanément avec une mémoire tampon » (« Buffered Array of Concurrent Servers » ou BACS en langue anglaise).

Plus précisément, l'invention porte sur un décodeur itératif comportant :
- une pluralité de serveurs qui effectuent chacun le décodage itératif d'un bloc de données;
- une mémoire tampon d'entrée pour stocker temporairement les blocs de données à décoder par les serveurs ;
- une unité de contrôle pour attribuer chaque bloc de données à décoder à un serveur ;
dans lequel le nombre d'itérations de la procédure de décodage effectuée par chaque serveur est déterminé sur la base d'un critère d'arrêt et l'unité de contrôle attribue des blocs de données à décoder aux différents serveurs à fur et à mesure qu'ils se rendent disponibles, caractérisée en ce que :
- la mémoire tampon d'entrée comporte N+L emplacements de mémoire, où N est le nombre de serveurs et L, en général >0, est le nombre d'emplacements dits supplémentaires;
- chaque bloc à décoder qui est reçu pendant que tous les serveurs sont occupés est stocké dans l'un des L emplacements supplémentaires éventuellement disponibles, ou il est perdu si la mémoire tampon d'entrée est entièrement remplie; et
- le nombre L d'emplacements supplémentaires et le nombre N de serveurs sont tels que la probabilité P_{B} qu'un bloc soit perdu, calculée sur la base d'un modèle de file d'attente du type D/G/N/N+L, vérifie la condition P_{B}≤α·FER*, où FER* est le taux d'erreur sur les blocs admis et α<1.
De préférence α≤0,01.

Selon différents modes de réalisation d'un décodeur itératif selon l'invention :
- parmi tous les couples de valeurs de L et de N permettant d'atteindre un débit Γ suffisamment élevé et une probabilité P_{B} de blocage suffisamment faible, est choisi celui qui minimise l'aire de silicium occupée par le décodeur;
- la mémoire tampon d'entrée est commune à tous les serveurs (22) et est accessible en parallèle ;
- les paquets de données stockés dans la mémoire tampon d'entrée sont attribués aux serveurs disponibles sur la base du principe premier entrant - premier sortant ( FIFO, « First-In-First-Out ») ;
- une mémoire tampon de sortie pour stocker temporairement les blocs de données décodés par les serveurs est également prévue ;
- l'unité de contrôle vérifie à intervalles réguliers si la condition d'arrêt pour chaque serveur est satisfaite ;
- dans un mode particulier de réalisation de l'invention la condition d'arrêt est vérifiée après chaque itération de la procédure de décodage;
- les serveurs sont des décodeurs choisis parmi : des décodeurs « turbo », des décodeurs « turbo-like », des décodeurs de contrôle de parité à faible densité (LDPC, « Low-Density Parity Check »), des décodeurs à effacement d'interférence (IC, « Interference Cancellation »), des décodeurs à effacement d'interférence en série (SIC, « Serial IC ») et des décodeurs à effacement d'interférence parallèles (PIC, « Parallel IC ») ;
- une mémoire extrinsèque utilisée par les serveurs lors du décodage est également prévue ;

L'invention porte également sur un système de communication utilisant un décodeur itératif tel que décrit ci-dessus.

L'invention porte également sur un procédé pour fabriquer un décodeur itératif tel que décrit ci-dessus comportant les étapes consistant à :
A) concevoir le décodeur en appliquant les sous-étapes consistant à :
   a) déterminer au moins un paramètre choisi parmi le débit Γ* des données à décoder, l'énergie par bit d'information E_{b}/N₀ du signal portant l'information à décoder, le taux d'erreur admissible sur les bits ou sur les blocs (BER* ou FER*), la probabilité de blocage maximale admissible P_{B}*, le rapport α entre cette probabilité et le taux d'erreur admissible, ainsi qu'une fonction de coût C(N,L) qui doit être minimisée par le décodeur;
   b) déterminer à partir d'au moins un dit paramètre un couple (N, L) qui minimise la fonction de coût C(N, L) ; et
B) réaliser un décodeur, ayant les valeurs N,L déterminées à la sous-étape A.b.

Selon une première variante, l'étape A.b comporte :
i. choisir un mode de réalisation des serveurs ;
ii. déterminer une valeur maximale Lₘₐₓ et une valeur minimale Lₘᵢₙ admissibles pour le nombre d'emplacements supplémentaires de mémoire tampon d'entrée ;
iii. utiliser les données obtenues lors de la sous-étape A.a pour calculer la fonction de densité de probabilité FDP du temps de service Tₛ, c'est à dire le temps nécessaire à un serveur pour décoder un bloc d'information de telle sorte que le taux d'erreur soit inférieur ou égal à BER* ou FER*, ainsi que la valeur attendue E{Tₛ} dudit temps de service ;
iv. poser initialement le nombre d'emplacements supplémentaires de mémoire tampon d'entrée égale à L= Lₘᵢₙ ;
v. poser initialement le nombre de serveur égale à N=Γ*·E{Tₛ} ;
vi. modéliser le décodeur comme un système à file d'attente du type D/G/N/N+L et calculer la probabilité de blocage P_{B} correspondante ;
vii. si P_{B}>P_{B}*=α·FER* ou α·BER*, augmenter N d'une unité et répéter la sous-étape vi ;
viii. autrement retenir le couple (N,L) ;
ix. si L*<Lₘₐₓ, augmenter L d'une unité (410) et recommencer la procédure à partir de l'étape v;
x. parmi tous les couples (N,L) retenu, choisir celui, (N*,L*), qui permet de minimiser la fonction de coût C(N,L) ;

Selon une deuxième variante, l'étape A.b comporte :
i. choisir un mode de réalisation des serveurs ;
ii. déterminer une valeur maximale Lₘₐₓ et une valeur minimale Lₘᵢₙ admissibles pour le nombre d'emplacements supplémentaires de mémoire tampon d'entrée ;
iii. utiliser les données obtenues lors de la sous-étape A.a pour calculer la fonction de densité de probabilité FDP du temps de service Tₛ, c'est à dire le temps nécessaire à un serveur pour décoder un bloc d'information de telle sorte que le taux d'erreur soit inférieur ou égal à BER* ou FER*, ainsi que la valeur attendue E{Tₛ} dudit temps de service ;
iv. poser initialement le nombre d'emplacements supplémentaires de mémoire tampon d'entrée égale à L= Lₘᵢₙ ;
v. prendre une valeur initiale du nombre de décodeur N*=N_{wc}=Γ*/Γₛₑᵣᵥ, Γₛₑᵣᵥ étant le débit de données de chaque serveur en considérant un nombre d'itérations de décodage Nᵢₜ fixé à la valeur nécessaire pour obtenir le taux d'erreur admissible FER* ou BER* ;
vi. modéliser le décodeur comme un système à file d'attente du type D/G/N/N+L et calculer la probabilité de blocage P_{B} correspondante ;
vii. si P_{B}< P_{B}*=αFER* (ou α BER*), diminuer N* d'une unité e répéter la sous-étape vi ;
viii. autrement retenir le couple (N+1,L) ;
ix. si L*<Lₘₐₓ augmenter L* d'une unité et recommencer la procédure à partir de l'étape v;
x. parmi tous les couples (N,L) retenu, choisir celui qui permet de qui permet de minimiser la fonction de coût C(N,L) ;

Selon une troisième variante, l'étape A.b comporte :
i. procéder à la conception d'un dit décodeur pour différentes valeurs de l'énergie par bit d'information E_{b}/N₀;
ii. choisir le couple (N*,L*) qui permet d'obtenir un taux d'erreur (BER* ou FER*) admissible au débit Γ* des données à décoder pour la plus faible valeur de l'énergie par bit d'information E_{b}/N₀, tout en donnant, pour la fonction de coût C(N,L), une valeur inférieure ou égale à une valeur maximale admissible C*;

Selon une quatrième variante, l'étape A.b comporte :
i. procéder à la conception d'un dit décodeur pour différentes valeurs du débit Γ ;
ii. choisir le couple (N*,L*) qui permet d'obtenir le débit Γ* le plus élevé un taux d'erreur (BER* ou FER*) admissible pour la valeur choisie de l'énergie par bit d'information E_{b}/N₀, tout en donnant, pour la fonction de coût C(N,L), une valeur inférieure ou égale à une valeur maximale admissible C*.

Selon un mode particulier de réalisation de l'invention, la fonction de coût C(N,L) considérée dans les procédés de fabrication décrits ci-dessus est proportionnelle aux dimensions physiques (complexité) du circuit électronique qui constitue le décodeur.

D'autres caractéristiques, détails et avantages de l'invention ressortiront à la lecture de la description faite en référence aux dessins annexés, donnés à titre d'exemple, et dans lesquels :
- les figures 1 A, 1 B et 1 C se référent à l'art antérieur évoqué dans le préambule ;
- la figure 2 montre un schéma de principe d'un décodeur selon l'invention et sert de base à l'exposition de son fonctionnement ;
- la figure 3 illustre la modélisation du décodeur qui permet son dimensionnement selon l'invention ;
- les figures 4A à 4D illustrent, sous la forme d'organigrammes, quatre procédés de dimensionnement d'un décodeur selon l'invention ; et
- les figures 5A et 5B illustrent un exemple de dimensionnement d'un décodeur selon l'invention ;
- la figure 6 montre comment la complexité d'un décodeur selon l'invention et d'un décodeur à nombre d'itérations fixé, équivalents en terme de débit et de taux d'erreur, varient en fonction de l'énergie par bit d'information (E_{b}/N₀) du signal à décoder.

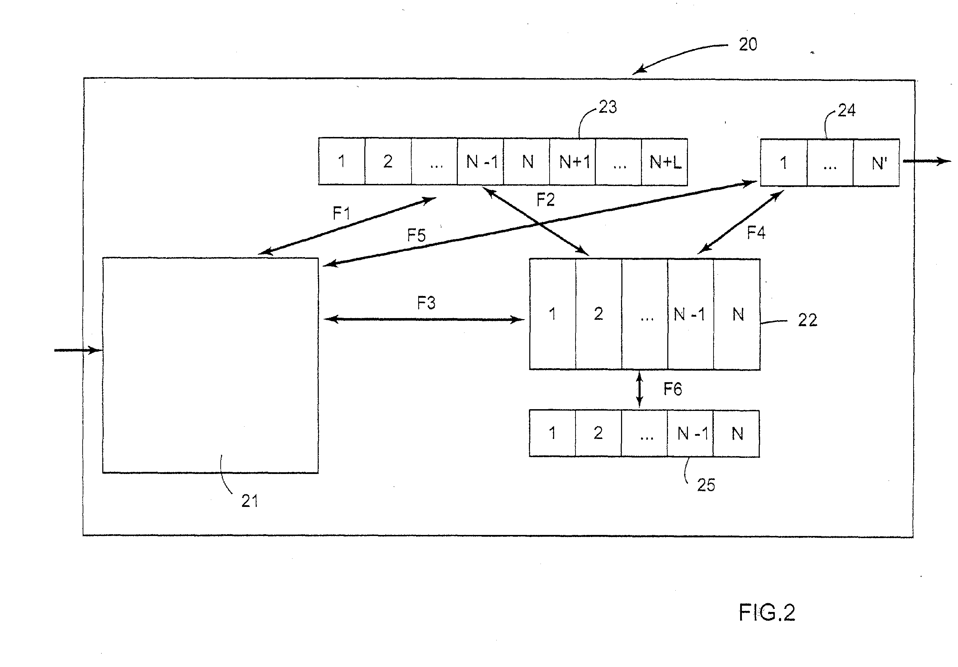

D'après la figure 2, un décodeur 20 selon l'invention comporte une unité de contrôle 21, un ensemble de N modules de décodage, ou « serveurs » 22, une mémoire tampon d'entrée 23 constituée de N+L emplacements, une mémoire tampon de sortie 24 constituée de N' emplacements et une mémoire extrinsèque 25 (N emplacements). Les doubles flèches F₁-F₅ matérialisent les échanges de données parmi les composantes du système.

Un paquet en cours de décodage ne peut pas être effacé de la mémoire tampon d'entrée 23 tant qu'il n'a pas été entièrement traité : pour cette raison cette mémoire doit comporter au moins N emplacements. De plus, si le code itératif utilisé est un code turbo, chaque serveur doit disposer d'au moins un emplacement de mémoire extrinsèque 25 pour stocker l'information échangée à chaque itération entre les deux décodeurs élémentaire qui le constituent (voir les références mentionnées ci-dessus sur les codes turbo). La mémoire extrinsèque peut éventuellement être absente dans le cas d'autres techniques de codage.

L'unité de contrôle 21 accomplit trois tâches :
- le multiplexage statistique des données en entrée, qui sont d'abord stockées dans la mémoire tampon d'entrée 23 (flèche F₁) et successivement traitées par l'un des serveurs appartenant à l'ensemble 22 (flèche F₂);
- le contrôle de la condition d'arrêt pour chaque serveur (flèche F₃): quand cette condition est vérifiée, le serveur en question arrête le traitement en cours, transfère le paquet de données décodé vers la mémoire tampon de sortie 24 (flèche F₄) et se dispose pour recevoir un nouveau paquet à décoder ; et
- la gestion de la mémoire tampon de sortie 24 (flèche F₅).

Une telle unité de contrôle peut être réalisée selon des techniques connues de l'homme du métier.

Suivant différentes variantes de l'invention, l'unité de contrôle 21 peut accomplir seulement une partie des taches mentionnées ci-dessus. Par exemple, chaque serveur peut vérifier de manière autonome sa propre condition d'arrêt. Le multiplexage statistique constitue cependant une caractéristique essentielle d'un décodeur selon l'invention.

Dans un mode préféré de réalisation de l'invention, l'attribution des paquets de données stockés dans la mémoire tampon d'entrée aux serveurs disponibles est gérée par l'unité de contrôle sur 21 la base du principe premier entrant - premier sortant (FIFO, « First-In-First-Out »), c'est à dire que les paquets sont traités dans le même ordre dans lequel ils sont reçus, mais d'autres principes peuvent être appliqués. Par exemple, si le décodage d'un paquet s'avère particulièrement long, il peut être interrompu pour faire face à une augmentation du débit de données en entrée et repris plus tard.

Avantageusement, plusieurs serveurs peuvent accéder simultanément à la mémoire tampon, qui est une ressource partagée.

Plusieurs modes de réalisation de modules de décodage itératif sont connus de l'homme du métier, pour cette raison leur structure et leurs performances ne seront pas discutées ici. Pour plus d'information voir, par exemple, les documents EP 1 022 860 B1, WO 01/06661 et EP 0 735 696 B1. Dans la suite on supposera que les serveurs sont identiques entre eux, mais le cas plus général de serveurs différents rentre dans le cadre de la présente invention.

Si un paquet de données à décoder est reçu pendant que tous les N serveur, et donc les N premiers emplacements de la mémoire tampon d'entrée, sont occupés, ledit paquet doit être stocké dans un des L emplacements de mémoire supplémentaires jusqu'à qu'un serveur soit libéré. Le décodeur constitue donc un système à file d'attente et ses performances peuvent être évaluées à l'aide de la « théorie des files d'attente», exposée par exemple dans le texte :
« Introduction to Queuing Systems », de S.K.Bose, Kluver/Plenum Publishers, 2001.

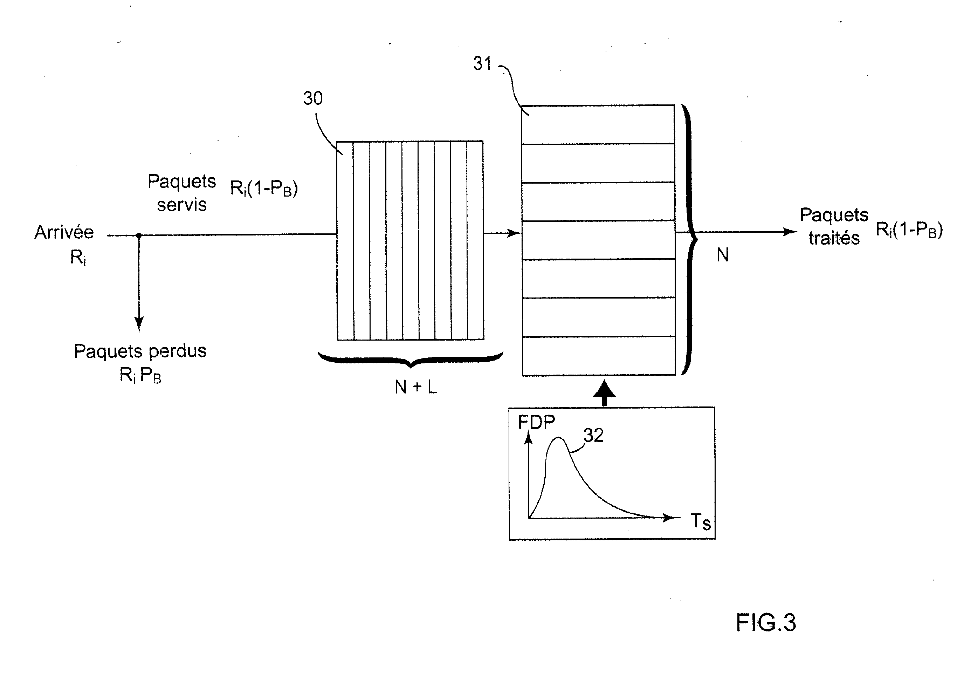

La figure 3 illustre la modélisation du système du point de vue de la théorie des files d'attente. Cette modélisation permet le dimensionnement d'un décodeur selon l'invention pour une application donnée, c'est à dire la détermination du nombre N de serveurs et du nombre L d'emplacements de mémoire supplémentaires en fonction du débit de données Γ* qui doit être obtenu, de l'écart signal et bruit (SNR, « Signal to Noise Ratio) et du taux d'erreurs (BER/FER) admissible. En fait, plutôt que le SNR, on utilise le rapport E_{b}/N₀, où E_{b} est l'énergie par bit d'information et N₀ la puissance moyenne du bruit. Le rapport entre le SNR et E_{b}/N₀ est l'efficacité spectrale η=R_{c}η_{M}, où R_{c} (« code rate ») est le rapport entre le nombre de bits d'information et le nombre de bits de code utilisés pour les transmettre et l'efficacité de modulation η_{M} est le nombre de bits de code porté par chaque symbole transmis.

Le débit de chaque serveur Γₛₑᵣᵥ, ainsi que l'aire de silicium occupée par chaque serveur (S_{dec}) et par chaque emplacement de mémoire tampon (S_{I/O}), sont considérés comme des paramètres externes, qui dépendent des choix technologiques effectués lors de la réalisation du décodeur.

Le décodeur est modélisé par un système à file d'attente du type D/G/N/N+L. Dans la notation de Kendall, couramment utilisée en théorie des files d'attente, cela signifie que le système est caractérisé par :
- un taux d'arrivée déterministe (D) des paquets en entrée, indiqué par Rᵢ ;
- un temps de service Tₛ aléatoire, décrit par une fonction de densité de probabilité (FDP) générique (G) ;
- N serveurs (figure 3, chiffre de référence 30); et
- N+L positions d'attente (figure 3, chiffre de référence 31).

Comme le nombre de positions d'attente est fini et le temps de service n'est pas déterministe, il est possible qu'un paquet arrive pendant que la file d'attente est pleine : ce paquet est donc perdu. La probabilité de perdre un paquet, dite probabilité de blocage, est indiquée par P_{B} et sa valeur doit être suffisamment petite pour ne pas affecter sensiblement les prestations du décodeur. Typiquement, on impose que P_{B} doit être inférieur au FER d'au moins deux ordres de grandeur : P_{B}≤α·FER*, avec α≈0.01.

En principe, le temps de service T_{S} est une variable aléatoire discrète qui peut prendre les valeurs Nᵢₜ·T_{S,min}, où T_{S,min} est le temps nécessaire à effectuer une itération et Nᵢₜ est un nombre entier compris entre 1, ce qui correspond au cas où la condition d'arrêt serait satisfaite après une seule itération, et +∞, car le décodage peut ne pas converger. En pratique, les règles d'arrêt prévoient toujours un nombre maximal d'itérations admissibles (par exemple 100). La courbe 32 sur la figure 3 représente une interpolation de la fonction de densité de probabilité (FDP) de T_{S}.

Bien que T_{S} soit, en principe, un temps, il est avantageux de le mesurer en nombre d'itérations, afin de s'affranchir des caractéristiques physiques du décodeur, qui dépendent de la technologie microélectronique utilisée.

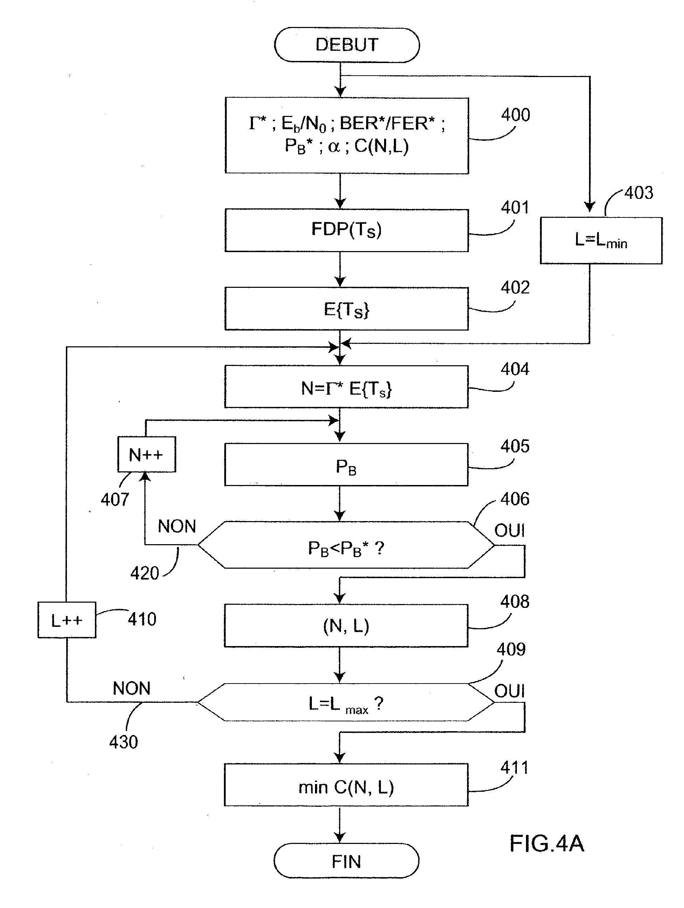

Comme illustré par l'organigramme sur la figure 4A, la première étape (400) du procédé de dimensionnement du décodeur consiste à déterminer le débit Γ* des données à décoder, le rapport E_{b}/N₀ du signal reçu, le taux d'erreur acceptable (BER*/FER*), la probabilité de blocage maximale (P_{B}*) ainsi qu'une fonction de coût (C(N,L)) adaptée. Ensuite, généralement à l'aide de simulations, on détermine de la FDP de T_{S} (étape 401).

Une fois déterminée la FDP, on peut calculer la valeur attendue de T_{S}, E{T_{S}}, ce qui constitue l'étape 402.

A l'étape 403, qui peut par exemple être simultanée à l'étape 402, on pose L=Lₘᵢₙ, où Lₘᵢₙ est l'extrême inférieur d'un intervalle déterminé a priori de valeurs admissibles pour le nombre d'emplacements de mémoire supplémentaires [Lₘᵢₙ, Lₘₐₓ], dans lequel typiquement Lₘᵢₙ=1.

A l'étape 404, une première estimation du nombre de serveur, N*, est calculée en considérant un nombre infini de positions d'attente. Dans ce cas, le débit moyen de chaque serveur est simplement 1/E(T_{S}). Le nombre de serveur nécessaire pour assurer un débit cible Γ* est donc N=Γ* E(T_{S}).

La probabilité de blocage P_{B} correspondant au couple (N, L) est calculée (étape 405) et comparée à la consigne P_{B}* (étape 406). Le calcul de P_{B} se fait par simple comptage des paquets perdus lors d'une série de simulations basées sur le modèle D/G/N/N+L et utilisant la FDP de T_{S} déterminée à l'étape 401. Pour plus de précisions concernant ces simulations, voir l'ouvrage de S.K.Bose cité ci-dessus.

Le couple (N,L) est retenu (étape 408) si P_{B}< P_{B}*, autrement N* est incrémenté d'une unité (étape 407) ; la boucle 420 est parcourue tant que la condition P_{B}< P_{B}* n'est vérifiée.

Si L<Lₘₐₓ (étape de test 409), le nombre d'emplacements de mémoire supplémentaires est incrémenté d'une unité (étape 410) et le cycle recommence de l'étape 404 (boucle 430).

Enfin, parmi tous les couples admissibles (N,L) l'on choisit celui, (N*,L*), qui minimise la fonction de coût, C(N,L), qui représente par exemple la surface de silicium occupée (étape 411). Si l'on néglige la complexité de l'unité de contrôle, la fonction de coût est par exemple donnée par C(N,L)= N·S_{dec}+L·S_{I/O}.

Le seul paramètre qui reste à déterminer est le nombre N' d'emplacements de la mémoire tampon de sortie. Sa valeur dépend de l'application spécifique : on peut par exemple considérer deux cas typiques : N'=N+L et N'=0 (mémoire de sortie complètement absente).

Du point de vue du temps de calcul, l'étape la plus onéreuse est certainement la détermination de P_{B}, qui doit être répétée pour chaque couple (N*, L*) et qui demande de réaliser un nombre important de simulations du système de file d'attente. L'autre étape qui demande un temps de calcul élevé est la détermination de la FDP(T_{S}), qui est effectuée à l'aide de plusieurs simulations de l'algorithme de décodage avec différents paquets en entrée. La distribution statistique du temps de service pour ces paquets est déterminée par la valeur de E_{b}/N₀ dans les conditions de fonctionnement pour lesquelles le décodeur est prévu et par le taux d'erreur (BER* ou FER*) admissible. Ces simulations peuvent être simplifiées considérablement en remplaçant la règle d'arrêt réellement appliquée dans le décodeur avec le critère d'arrêt dit « aidé par Génie » : l'itération est arrêtée quand un paquet a été décodé correctement. Evidemment, un tel critère ne peut être appliqué que dans le cadre d'une simulation, où les paquets de données sont parfaitement connus. Le critère « aidé par Génie » est généralement complété par un critère d'arrêt au bout d'un nombre maximal d'itérations pour empêcher que le décodeur reste bloqué dans une boucle infinie. Le nombre maximal d'itérations est choisi de telle sorte que le taux d'erreur soit inférieur ou égal à BER* ou FER*. L'expérience montre que cette approche simplifiée donne des résultats suffisamment proches de ceux obtenus en appliquant des critères d'arrêt réalistes.

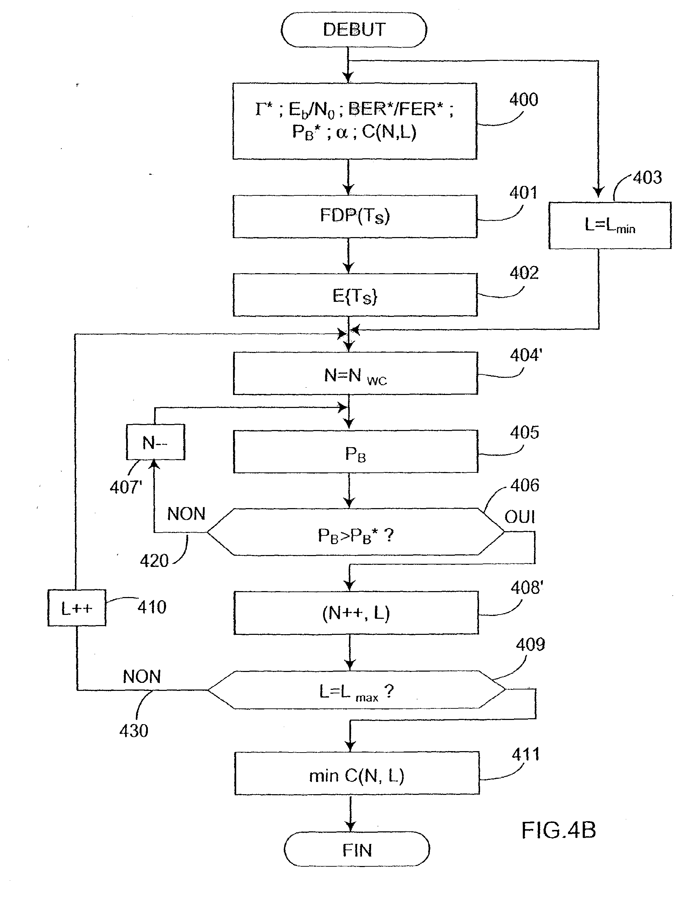

Un procédé alternatif est illustré sur la figure 4B. Dans ce procédé la détermination de N et L peut être effectuée en partant d'un nombre de serveur N*=N_{wc}=Γ*/Γₛₑᵣᵥ, égal à celui qui serait nécessaire dans le cas d'une architecture parallèle à nombre d'itérations fixé (étape 404'), et d'un nombre arbitraire L d'emplacements supplémentaires de mémoire. Cette première estimation du nombre de serveurs est indiquée par N_{wc}, où « wc » signifie « worst case » (pire des cas) car en général il s'agit d'une estimation par excès. La probabilité d'arrêt P_{B} est donc calculée et comparée à P_{B}* ; N est ensuite diminué (étape 407') jusqu'à que P_{B}> P_{B}* : à ce point la valeur de N+1, c'est à dire le nombre de serveur déterminé à l'avant-dernière itération, est retenue (étape 408'). Le cycle est répété pour toutes les valeurs admissibles de L. Ce deuxième procédé de dimensionnement donne exactement les mêmes résultats que celui représenté sur la figure 4A, mais nécessite d'un nombre plus élevé de simulations et présente donc un intérêt moindre.

Dans les figures 4A et 4B, les opérateurs « ++ » et « - - » représentent respectivement l'incrément et le décrément d'une unité.

On considère maintenant un exemple concret de conception d'un décodeur selon l'invention. L'algorithme de décodage utilisé est un code turbo en série, obtenu en concaténant deux codes : le code externe est un convolutionnel à 16 états avec taux 1/2, le code interne est un code différentiel à 2 états avec taux 1/1. La séquence à la sortie est entrelacée avec une loi pseudo-aléatoire (« S-random law »). Pour plus de précision sur ce type de code, voir :
« Serial concatenation of interleaved codes: Performance analysis, design, and itérative decoding », S. Benedetto et al. IEEE Trans. Inform. Theory, 44(3) : 909-926, 1998 ;
en ce qui concerne l'algorithme d'entrelacement voir :
« Turbo codes for PCS applications », F. Pollara et D. Divsalar, IEEE International Conference on Communications, ICC 95, 1 :54-59, juin 1995.

Les serveurs et les mémoires tampons sont réalisés de manière conventionnelle ; pour des exemples d'architectures de décodeurs itératifs pouvant être utilisés comme serveurs dans une réalisation de la présente invention, voir :
« VLSI Architectures for Turbo Codes », G. Masera, G. Piccinini, M. Ruo Roch, M. Zamboni, IEEE Trans. on VLSI Systems, Vol. 7 : 369-379, 1999 ;
« VLSI Architectures for the MAP Algorithm », E. Boutillon, W.J. Gross, IEEE Trans. on Communication, Vol. 51 :175-185, 2003 ; et
« A 50 Mbit/s Iterative Turbo Decoder », F. Viglione, G.
Masera, G. Piccinini, M. Ruo Roch, M. Zamboni, Design, Automation and Test in Europe, DATE'00, Mars 2002, Paris.

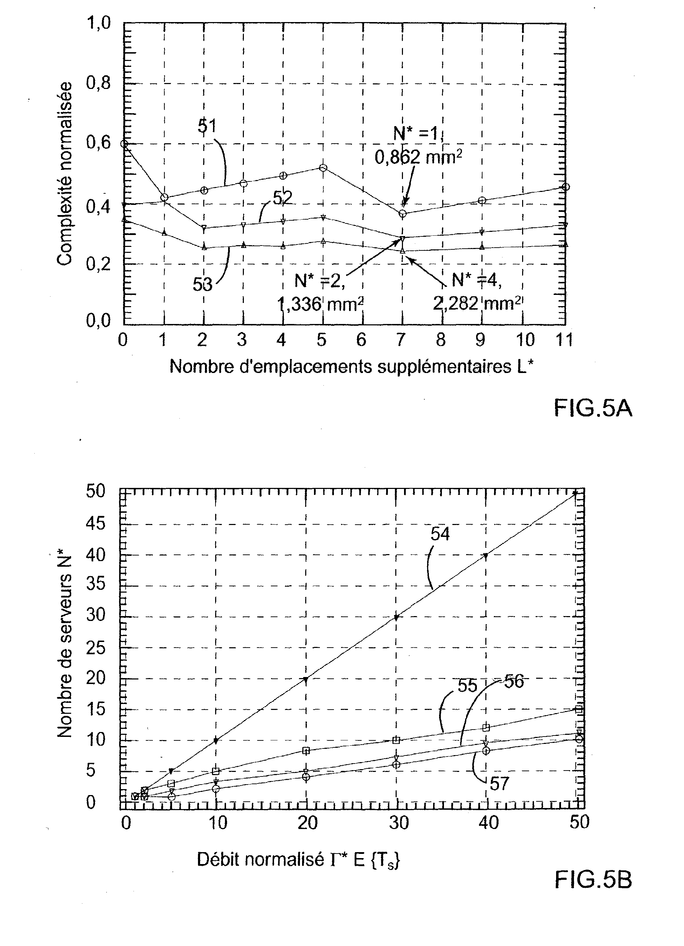

La technologie microélectronique utilisée est le procédé HCMOS à 0,18 µm de « Taiwan Semicondutor Manufacturing Company » (TSMC). La transmission des données est caractérisée par une efficacité spectrale η=1 bps/Hz et un rapport E_{b}/N₀=2,75 dB. On utilise une modulation par déphasage en quadrature (QPSK) avec r=1/2 et des blocs d'une longueur K=748 bits ; le FER admissible est de 10⁻⁵ et P_{B}*=10⁻⁷. Dans ces conditions, la figure 5A montre la complexité (aire de silicium) du décodeur, normalisée par rapport au cas d'une architecture à nombre d'itérations fixées, pour Γ*=5/E{T_{S}} (courbe 51), Γ*=10/E{T_{S}} (courbe 52) et Γ*=20/E{T_{S}} (courbe 53). Dans les trois cas, le nombre optimal d'emplacements supplémentaires de mémoire est 7, alors que N* vaut 1, 2 et 4 respectivement. On voit que le gain en terme de complexité par rapport aux architectures à nombre d'itérations fixées augmente avec le débit de données et atteint un facteur 4 pour Γ*=20/E{T_{S}}. La complexité réelle, en mm², est indiquée sur la figure pour chaque configuration optimale.

En fonction des contraintes liées à la technologie de réalisation d'un décodeur selon l'invention, des fonctions de coût autres que la complexité peuvent être prises en compte lors de la conception.

La figure 5B montre la dépendance du nombre de serveurs à utiliser pour obtenir un débit Γ* donné, exprimé en unité 1/E{T_{S}}, pour différentes architectures de décodeur. La courbe 54 se réfère à une des architectures de la figure 1, qui ne permettent pas l'application d'une règle d'arrêt ; le nombre de serveurs est donc simplement égale au produit Γ*·E{T_{S}}. La courbe 55 correspond au cas L=0 : les serveurs doivent être en nombre suffisant pour que la probabilité qu'ils soient tous occupés au même instant soit suffisamment faible, plus précisément inférieure ou égale à P_{B}*. La courbe 56 a été calculée pour L=5 ; enfin, la courbe 57 correspond à une mémoire tampon illimitée.

Dans le cas Γ*=50, par exemple, l'utilisation d'un critère d'arrêt, et donc d'un multiplexage statistique des paquets, même sans emplacements supplémentaires de mémoire, réduit le nombre de serveurs de 50 à 15. L'adjonction de 5 emplacements de mémoire réduit le nombre de serveurs à 11, ce qui est encore très avantageux, alors que même une mémoire tampon « infinie » ne permet pas de descendre au-dessous de 10 serveurs : il n'est donc pas utile d'augmenter excessivement la valeur de L. En fait, dans le cas considéré, la faible longueur des blocs (K=748 bits) rend la complexité du système peu sensible aux variations de L. Si l'on considère des blocs sensiblement plus longs, la complexité augmente fortement si le nombre d'emplacements de mémoire dépasse sa valeur optimale.

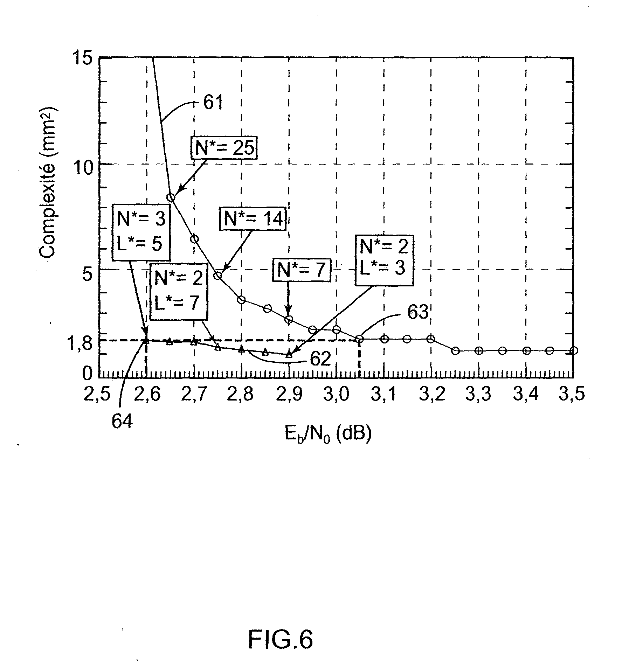

Jusqu'à présent on a toujours considéré le cas d'un système de communication avec un débit Γ* et un rapport E_{b}/N₀ (et donc un écart signal et bruit) imposés, et on s'est proposé de minimiser la complexité du décodeur. L'amélioration des performances du décodeur obtenue par la présente invention peut aussi être exploitée pour diminuer l'écart signal et bruit, et donc la puissance transmise, tout en maintenant la complexité du système (ou une autre fonction de coût) dans des limites acceptables. Sur la figure 6 est représenté la complexité, en mm² de silicium, en fonction de E_{b}/N₀ pour un décodeur à nombre d'itération fixé (courbe 61, cercles) et pour un décodeur selon l'invention (courbe 62, triangles). Les caractéristiques du système de transmission sont les mêmes que pour les figures 5A et 5B, avec Γ*=10/E{T_{S}}. On voit que pour une complexité fixée, par exemple, à 1,8 mm², la présente invention permet de réduire E_{b}/N₀ de 3,25 (point 63) à 2,6 dB (point 64), ce qui conduit à une diminution de la puissance transmise de 14% environ. On comprend facilement l'intérêt de l'invention, notamment dans les applications spatiales et de téléphonie mobile, où la consommation d'énergie est particulièrement critique.

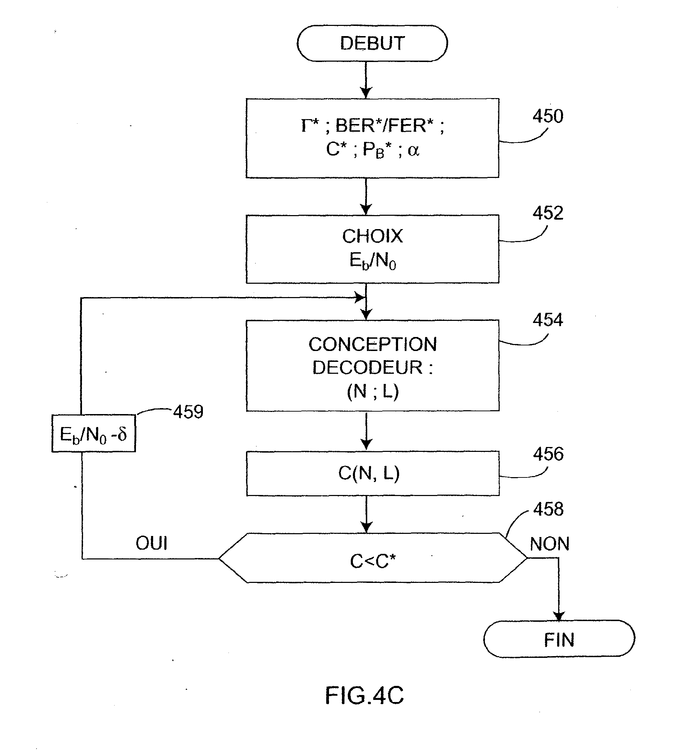

Un procédé de dimensionnement pour un décodeur selon l'invention visant à minimiser la puissance transmise, et donc le rapport E_{b}/N₀ du signal à décoder, est illustré sur la figure 4C.

On commence par déterminer le débit Γ*, le taux d'erreur (BER*/FER*) et la probabilité de blocage (P_{B}*) admissibles, une fonction de coût (C(N,L)) et une valeur maximale admissible (C*) de ladite fonction de coût (étape 450). A l'étape 452 une première valeur d'essai de E_{b}/N₀ est choisie ; à l'étape 454 un décodeur est dimensionné, par un des procédés illustrés sur les figures 4A et 4B, pour cette valeur de E_{b}/N₀ et (étape 456) la valeur correspondante de C(N,L) est calculée. Si cette valeur est inférieure à C* (étape de test 458) on diminue E_{b}/N₀ d'une quantité prédéterminée δ (étape 459) et on recommence depuis l'étape 454, autrement on retient le dernier couple (N,L) pour lequel C≤C*. Evidemment, si C>C* à la première itération, il est nécessaire de recommencer avec une valeur plus élevée de E_{b}/N₀. Il est important d'observer que, pour chaque valeur de E_{b}/N₀, la PDF(T_{S}) doit être recalculée.

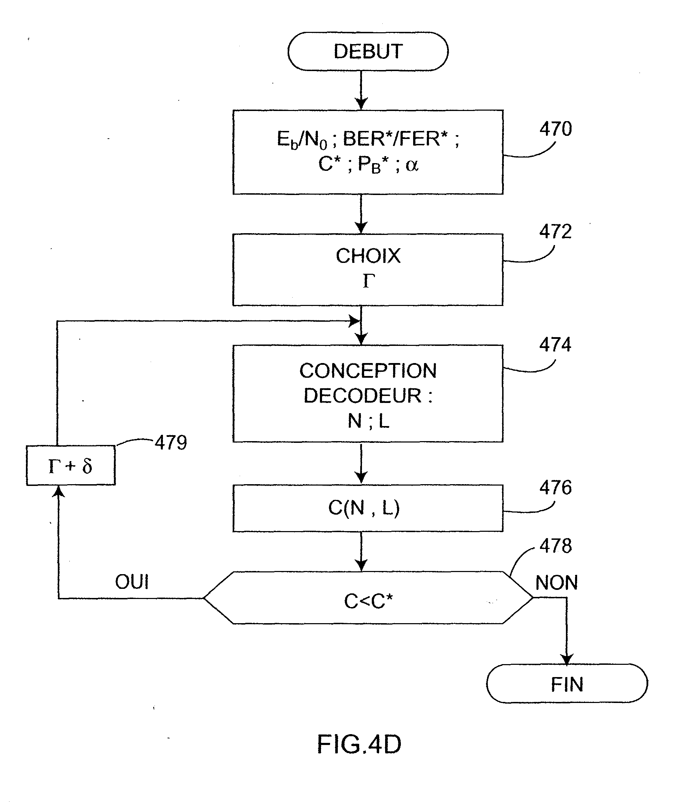

Encore, il est possible de choisir le couple (N*, L*) de façon à maximiser le débit Γ pour une complexité (ou une valeur d'une autre fonction de coût) et un rapport E_{b}/N₀ donnés, comme illustré par la figure 4D.

On commence par déterminer le taux d'erreur (BER*/FER*) et la probabilité de blocage (P_{B}*) admissibles, le rapport E_{b}/N₀, une fonction de coût (C(N,L)) et une valeur maximale admissible (C*) de ladite fonction de coût (étape 470). A l'étape 472 une première valeur d'essai du débit Γ est choisie ; à l'étape 474 un décodeur est dimensionné, par un des procédés illustrés sur les figures 4A et 4B, pour cette valeur de Γ et (étape 476) la valeur correspondante de C(N,L) est calculée. Si cette valeur est inférieure à C* (étape de test 478) on augmente Γ d'une quantité prédéterminée δ (étape 479) et on recommence depuis l'étape 474, autrement on retient le dernier couple (N,L) pour lequel C≤C*. Evidemment, si C>C* à la première itération, il est nécessaire de recommencer avec une valeur plus faible de Γ.

L'homme du métier peut facilement perfectionner ces procédés : par exemple, quand C dépasse C* pour la première fois, on peut diminuer la valeur de δ pour s'approcher plus de la valeur minimale admissible de E_{b}/N₀ (figure 4C) ou du débit maximal (figure 4D).

D'autres possibles critères d'optimisation du décodeur apparaîtront de manière évidente à l'homme du métier en fonction de l'application spécifique pour laquelle un décodeur selon la présente invention est prévu.

Dans les procédés 4A - 4D il est entendu que certaines des étapes peuvent être effectuées simultanément.

Bien que dans la description détaillée seul le cas particulier des codes turbo ait été considéré, la présente invention s'applique également au décodage de tous les autres codes itératifs tels que, par exemple, les codes « turbo-like », des codes de contrôle de parité à faible densité (LDPC, « Low-Density Parity Check »), les codes d'effacement d'interférence (IC, « Interference Cancellation »), les codes d'effacement d'interférence en série (SIC, « Serial IC ») et les codes d'effacement d'interférence parallèles (PIC, « Parallel IC »), sans que cette liste ne puisse être considérée exhaustive.

## Revendications

1. Décodeur itératif (20) comportant :
- une pluralité de serveurs (22) qui effectuent chacun le décodage itératif d'un bloc de données;
- une mémoire tampon d'entrée (23) pour stocker temporairement les blocs de données à décoder par les serveurs (22), comportant N+L emplacements de mémoire, où N est le nombre de serveurs (22) et L est le nombre d'emplacements dits supplémentaires; et
- une unité de contrôle (21) pour attribuer chaque bloc de données à décoder à un serveur ;
- dans lequel l'unité de contrôle (21) attribue des blocs de données à décoder aux différents serveurs (22) à fur et à mesure qu'ils se rendent disponibles,
**caractérisé en ce que** :
- le nombre d'itérations de la procédure de décodage effectuée par chaque serveur (22) est déterminé sur la base d'un critère d'arrêt ; **en ce que**
- chaque bloc à décoder qui est reçu pendant que tous les serveurs (22) sont occupés est stocké dans l'un des L emplacements supplémentaires éventuellement disponibles, ou il est perdu si la mémoire tampon d'entrée (23) est entièrement remplie; et **en ce que**
- le nombre L d'emplacements supplémentaires et le nombre N de serveurs sont tels que la probabilité P_{B} qu'un bloc soit perdu, calculée sur la base d'un modèle de file d'attente du type D/G/N/N+L, vérifie la condition P_{B}≤α·FER*, où FER* est le taux d'erreur sur les blocs admis et α<1.

2. Décodeur itératif (20) selon la revendication 1, dans lequel α≤0,01.

3. Décodeur itératif (20) selon la revendication 1 ou 2 dans lequel, parmi tous les couples de valeurs de L et de N permettant d'atteindre un débit Γ suffisamment élevé et une probabilité P_{B} de blocage suffisamment faible, est choisi celui qui minimise l'aire de silicium occupée par le décodeur (20)

4. Décodeur itératif (20) selon l'une des revendications précédentes, dans lequel la mémoire tampon d'entrée (23) est commune à tous les serveurs (22) et est accessible en parallèle.

5. Décodeur itératif (20) selon l'une des revendications précédentes, dans lequel les paquets de données stockés dans la mémoire tampon d'entrée sont attribués aux serveurs disponibles sur la base du principe premier entrant - premier sortant ( FIFO, « First-In-First-Out »).

6. Décodeur itératif (20) selon l'une des revendications précédentes, comportant également une mémoire tampon de sortie (24) pour stocker temporairement les blocs de données décodés par les serveurs (22).

7. Décodeur itératif (20) selon l'une des revendications précédentes, dans lequel l'unité de contrôle (21) vérifie à intervalles réguliers si la condition d'arrêt pour chaque serveur (22) est satisfaite.

8. Décodeur itératif (20) selon la revendication 7, dans lequel la condition d'arrêt est vérifiée après chaque itération de la procédure de décodage.

9. Décodeur itératif (20) selon l'une des revendications précédentes, dans lequel les serveurs (22) les serveurs sont des décodeurs choisis parmi : des décodeurs « turbo », des décodeurs « turbo-like », des décodeurs de contrôle de parité à faible densité (LDPC, « Low-Density Parity Check »), des décodeurs d'effacement d'interférence (IC, « Interference Cancellation »), des décodeurs d'effacement d'interférence en série (SIC, « Serial IC ») et des décodeurs d'effacement d'interférence parallèles (PIC, « Parallel IC »).

10. Décodeur itératif (20) selon l'une des revendications précédentes, comportant également une mémoire extrinsèque (25) utilisée par les serveurs (22) lors du décodage.

11. Système de communication utilisant un décodeur itératif selon l'une des revendications précédentes.

12. Procédé de fabrication d'un décodeur itératif selon l'une des revendications 1 à 10 comportant les étapes suivantes :
A) concevoir le décodeur en appliquant les sous-étapes suivantes :
a) déterminer au moins un des paramètres suivants : le débit (Γ*) des données à décoder, l'énergie par bit d'information (E_{b}/N₀) du signal portant l'information à décoder, le taux d'erreur admissible sur les bits ou sur les blocs (BER* ou FER*), la probabilité de blocage maximale admissible (P_{B}*), le rapport (α) entre cette probabilité et le taux d'erreur admissible, ainsi qu'une fonction de coût (C(N,L)) qui doit être minimisée par le décodeur;
b) déterminer à partir d'au moins un desdits paramètres un couple (N,L) qui permet de minimiser la fonction de coût C(N,L) ; et
B) réaliser un décodeur, ayant les valeurs N,L déterminées à la sous-étape A.b.

13. Procédé selon la revendication 12, **caractérisé en ce que** A.b comporte :
i. choisir un mode de réalisation des serveurs (22) ;
ii. déterminer une valeur maximale (Lₘₐₓ) et une valeur minimale (Lₘᵢₙ) admissibles pour le nombre d'emplacements supplémentaires de mémoire tampon d'entrée (23) (403) ;
iii. utiliser les données obtenues lors des deux premières sous-étapes pour calculer la fonction de densité de probabilité (FDP) du temps de service (Tₛ), c'est à dire le temps nécessaire à un serveur (22) pour décoder un bloc d'information, ainsi que la valeur attendue (E{Tₛ}) dudit temps de service (401 ; 402);
iv. poser initialement le nombre d'emplacements supplémentaires de mémoire tampon d'entrée (23) égale à L= Lₘᵢₙ(403) ;
v. poser initialement le nombre de serveur égale à N=Γ*·E{Tₛ} (404) ;
vi. modéliser le décodeur comme un système à file d'attente du type D/G/N/N+L et calculer la probabilité de blocage P_{B} correspondante (405) ;
vii. si P_{B}>P_{B}*=α·FER* ou α·BER* (406), augmenter N d'une unité (407) et répéter la sous-étape vi ;
viii. autrement retenir le couple (N,L) (408);
ix. si L*<Lₘₐₓ (409) augmenter L d'une unité (410) et recommencer la procédure à partir de l'étape v;
x. parmi tous les couples (N,L) retenu, choisir celui (N*,L*) qui permet de minimiser la fonction de coût (C(N,L))(411) ;

14. Procédé selon la revendication 12, **caractérisé en ce que** A.b comporte :
i. choisir un mode de réalisation des serveurs (22) ;
ii. déterminer une valeur maximale (Lₘₐₓ) et une valeur minimale (Lₘᵢₙ) admissibles pour le nombre d'emplacements supplémentaires de mémoire tampon d'entrée (23) ;
iii. utiliser les données obtenues lors des deux premières sous-étapes pour calculer la fonction de densité de probabilité (FDP) du temps de service (Tₛ), c'est à dire le temps nécessaire à un serveur (22) pour décoder un bloc d'information de telle sorte que le taux d'erreur soit inférieur ou égal à BER* ou FER*, ainsi que la valeur attendue (E{Tₛ}) dudit temps de service (401 ; 402) ;
iv. poser initialement le nombre d'emplacements supplémentaires de mémoire tampon d'entrée (23) égale à L= Lₘᵢₙ (403) ;
v. prendre une valeur initiale du nombre de décodeur N* suffisamment élevée pour que la probabilité de blocage P_{B} soit inférieure à P_{B}^{*} même si L=0 (404') ;
vi. modéliser le décodeur comme un système à file d'attente du type D/G/N/N+L et calculer la probabilité de blocage P_{B} correspondante (405) ;
vii. si P_{B}< P_{B}*=αFER* (ou α BER*) (406), diminuer N* d'une unité e répéter la sous-étape vi (407') ;
viii. autrement retenir le couple (N+1 ,L) (408');
ix. si L*<Lₘₐₓ (409) augmenter L* d'une unité (410) et recommencer la procédure à partir de l'étape v;
x. parmi tous les couples (N,L) retenu, choisir celui qui permet de qui permet de minimiser la fonction de coût (C(N,L)) (411) ;

15. Procédé selon la revendication 12 **caractérisé en ce que** A.b comporte :
i. procéder à la conception d'un décodeur pour différentes valeurs de l'énergie par bit d'information (E_{b}/N₀) (452, 454);
ii. choisir le couple (N*,L*) qui permet d'obtenir un taux d'erreur (BER* ou FER*) admissible au débit (Γ*) des données à décoder pour la plus faible valeur de l'énergie par bit d'information (E_{b}/N₀), tout en donnant, pour la fonction de coût (C(N,L)), une valeur inférieure ou égale à une valeur maximale admissible (C*) (456, 458, 459);

16. Procédé selon la revendication 12, **caractérisé en ce que** A.b comporte :
i. procéder à la conception d'un décodeur pour différentes valeurs du débit (Γ) (472, 474);
ii. choisir le couple (N*,L*) qui permet d'obtenir le débit (Γ*) le plus élevé un taux d'erreur (BER* ou FER*) admissible pour la valeur choisie de l'énergie par bit d'information (E_{b}/N₀), tout en donnant, pour la fonction de coût (C(N,L)), une valeur inférieure ou égale à une valeur maximale admissible (C*) (476, 478, 459).

17. Procédé selon l'une des revendications 12 à 16, dans lequel la fonction de coût (C) est proportionnelle aux dimensions physiques du circuit électronique qui constitue le décodeur.
